# EUROPEAN PATENT APPLICATION

(11) **EP 4 089 791 A1**
(43) Date of publication of application: **16.11.2022**
(21) Application number: 21767364.9
(22) Date of filing: 18.01.2021
(51) Int. Cl.: H01M 10/48, H01M 50/531, G01B 7/24, H01M 10/052, H01M 4/38

(54) **SECONDARY BATTERY AND LITHIUM PRECIPITATION DETECTION METHOD THEREFOR**

(30) Priority: 11.03.2020 KR 20200030312
(71) Applicant: LG Energy Solution, Ltd., Seoul 07335 (KR)
(72) Inventor: MIN, Kyoung Choon, Daejeon 34122 (KR)
(74) Representative: Plasseraud IP
(86) International application number: PCT/KR2021/000647
(87) International publication number: WO 2021/182741

(57) **Abstract**

The present invention relates to a secondary battery and a method for detecting lithium dendrite thereof. The secondary battery includes: a positive electrode and a negative electrode; a battery case configured to seal the positive electrode and the negative electrode; and a lithium dendrite detection means provided around a tab of the positive electrode at a side of the battery case to detect lithium dendrite.

## Description

### CROSS-REFERENCE TO RELATED APPLICATION

This application claims the priority of Korean Patent Application No. 10-2020-0030312, filed on March 11, 2020, in the Korean Intellectual Property Office, the disclosure of which is incorporated herein by reference.

### TECHNICAL FIELD

The present invention relates to a secondary battery and a method for detecting lithium dendrite thereof.

### BACKGROUND ART

Recently, with the spread of electronic devices such as smartphones, uninterruptible power supplies (UPS), and electric vehicles, and the spread of infrastructure for energy storage systems (ESS), studies on secondary batteries as a power supply source have been actively conducted. Such a secondary battery is provided in the form of a battery pack including a battery module in which a plurality of battery cells are connected in series and/or in parallel, and a battery management system (BMS) for managing an operation of the battery module.

In the case of a lithium secondary battery that uses lithium ions for an oxidation-reduction reaction among various secondary batteries, lithium dendrite may occur in an electrode according to the use environment of charging and discharging. When the lithium dendrite occurs, characteristics of the battery cell may be changed, and thus, it is necessary to detect early lithium dendrite. However, there was no means for detecting the lithium dendrite in the already manufactured battery cell.

### DISCLOSURE OF THE INVENTION

### TECHNICAL PROBLEM

Embodiments of the present invention have been made in consideration of the above problems, and an object of the present invention is to provide a secondary battery that is capable of accurately detecting lithium dendrite in the secondary battery and a method for detecting the lithium dendrite thereof.

### TECHNICAL SOLUTION

To solve the above problem, according to one aspect of embodiments of the present invention, provided is a secondary battery including: a positive electrode and a negative electrode; a battery case configured to seal the positive electrode and the negative electrode; and a lithium dendrite detection means provided around a tab of the positive electrode at a side of the battery case to detect lithium dendrite.

According to another feature of this embodiment, the lithium dendrite detection means may include a magnetic sensor provided on a tab area of the positive electrode in the battery case.

According to further another feature of this embodiment, the magnetic sensor may be mounted to detect a variation in magnetic field generated between the tab area of the positive electrode and the negative electrode.

According to further another feature of this embodiment, the magnetic sensor may detect magnetic fields generated based on current flowing from an over-coated portion of the tab area of the positive electrode to the negative electrode.

According to further another feature of this embodiment, the lithium dendrite detection means may include a deformation detection sensor provided on a tab area of the positive electrode in the battery case.

According to further another feature of this embodiment, the deformation detection sensor may be a strain gauge.

According to further another feature of this embodiment, the strain gauge may be formed on a side of a surface of the battery case, which is in contact with the positive electrode, or a side of a surface of the battery case, from which the tab extends.

According to further another feature of this embodiment, the battery case may be a flexible pouch.

To solve the above problem, according to another aspect of embodiments of the present invention, provided is a method for detecting lithium dendrite in a second battery, in which a positive electrode and a negative electrode are accommodated in a battery case, the method including: a step of detecting a variation of a preset parameter based on a lithium dendrite detection means provided around a tab of the positive electrode at a side of the battery case; a step of determining whether the variation of the parameter is equal to or less than a reference value; and a step of determining lithium dendrite based on the determined results.

According to another feature of this embodiment, the lithium dendrite detection means may include a magnetic sensor provided on a tab area of the positive electrode in the battery case, and in the step of detecting the variation of the parameter, a variation in magnetic field, which is measured by the magnetic sensor, may be detected.

According to further another feature of this embodiment, the lithium dendrite detection means may include a deformation detection sensor provided on a tab area of the positive electrode in the battery case, and in the step of detecting the variation of the parameter, deformation of the battery case that is a flexible pouch, which is measured by the deformation detection sensor, may be detected.

### ADVANTAGEOUS EFFECTS

According to the secondary battery having the above-described configuration and the method for detecting the lithium dendrite of the secondary battery, the lithium dendrite may be detected in the secondary battery that is in the sealed state.

### BRIEF DESCRIPTION OF THE DRAWINGS

FIG. 1 is a schematic view illustrating an electrode assembly of a secondary battery.
FIG. 2 is an assembly diagram of a pouch type secondary battery.
FIG. 3 is a conceptual view of a secondary battery for explaining a shape of lithium dendrite.
FIG. 4 is a conceptual cross-sectional view of the secondary battery for explaining an effect of the lithium dendrite.
FIG. 5 is a view illustrating a configuration of the secondary battery according to an embodiment of the inventive concept.
FIG. 6 is a conceptual cross-sectional view of the secondary battery according to an embodiment of the present invention.
FIG. 7 is a view illustrating a battery pack to which the secondary battery is applied according to an embodiment of the present invention.
FIG. 8 is a flowchart illustrating a method for detecting lithium dendrite of the secondary battery of FIG. 7.
FIG. 9 is a view illustrating a configuration of a secondary battery according to another embodiment of the inventive concept.
FIG. 10 is a flowchart illustrating a method for detecting lithium dendrite of the secondary battery of FIG. 9.
FIG. 11 is a view illustrating a configuration of a secondary battery according to further another embodiment of the present invention.

### MODE FOR CARRYING OUT THE INVENTION

Hereinafter, various embodiments will be described in detail with reference to the accompanying drawings. In this document, the same reference numerals are used for the same components in the drawings, and duplicated descriptions of the same components will be omitted.

For the various embodiments of the present invention disclosed in this document, specific structural or functional descriptions have been exemplified for the purpose of describing the embodiments of the present invention only, and various embodiments of the present invention may be implemented in various forms and should not be construed as being limited to the embodiments described in this document.

Expressions such as "first", "second", "firstly", or "secondly" used in various embodiments may modify various elements regardless of their order and/or importance and may not limit the corresponding elements. For example, the first component may be referred to as the second element, and similarly, the second component may be referred to as the first component without departing from the scope of the present invention.

Terms used in this document are only used to describe a specific embodiment and may not be intended to limit the scope of other embodiments. The terms of a singular form may include plural forms unless referred to the contrary.

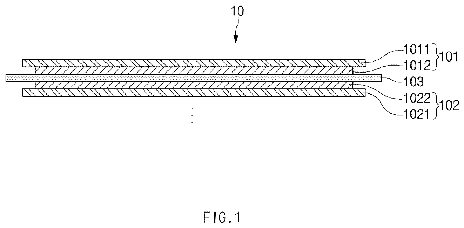

FIG. 1 is a schematic view illustrating an electrode assembly 10 of a secondary battery. In embodiments of the present invention, a case in which a lithium secondary battery is used as a secondary battery will be described.

In the electrode assembly 10 according to an embodiment of the present invention, first, slurry in which a positive electrode active material 1012, a binder, and a conductive agent are mixed is applied to a positive electrode collector 1011, and slurry in which a negative electrode active material 1022, the binder, and the conductive agent are mixed is applied to a negative electrode collector 1021 to manufacture a positive electrode (cathode) 101 and a negative electrode (anode) 102. Also, unit cells are formed by stacking the manufactured positive electrode 101 and negative electrode 102 with a separator 103 therebetween. Again, the unit cells are stacked on each other to form the electrode assembly 10 having a predetermined shape, as illustrated in FIG. 1.

The positive electrode 101 and the negative electrode 102, which are used in the present invention, are not particularly limited to both electrodes 101 and 102 and thus may be manufactured in a shape in which the electrode active materials 1012 and 1022 are bonded to the electrode collectors 1011 and 1021 according to the conventional method known in the art. Here, the positive electrode 101 may be manufactured by, for example, applying the slurry, in which the positive electrode active material 1012, the conductive agent, and the binder are mixed, onto a positive electrode collector 1011, and then drying and pressing the slurry. At this time, if necessary, the slurry may further include a filler. The positive electrode 101 may be manufactured in a sheet shape and then mounted on a roll.

The positive electrode collector 1011 generally has a thickness of 3 µm to 500 µm. The positive electrode collector 1011 is usually made of a material having high conductivity without causing a chemical change. Such a material may be surface-treated with, for example, stainless steel, aluminum, nickel, titanium, calcined carbon, or aluminum or stainless steel on which carbon, nickel, titanium, silver, or the like is surface-treated on a surface thereof, but is not limited thereto. Also, the positive electrode collector 1011 may form a fine unevenness on a surface of the positive electrode collector 1012 to increase in adhesion of the positive electrode active material 1012. Also, the positive electrode collector 1011 may have various shapes such as a film, a sheet, a foil, a net, a porous body, a foam, or a non-woven fabric.

The positive electrode active material 1012 may include, for example, a layered compound of lithium cobalt oxide (LiCoO₂), lithium nickel oxide (LiNiO₂), etc., or a substituted compound with one or more transition metals; lithium manganese oxide such as Li₁₊ₓMn₂₋ₓO₄ (x is 0 to 0.33), LiMnO₃, LiMn₂O₃, LiMnO₂, etc.; lithium copper oxide (Li₂CuO₂); vanadium oxide such as LiV₃O₈, LiFe₃O₄, V₂O₅, Cu₂V₂O₇, etc.; Ni site-type lithium nickel oxide represented by Chemical Formula of LiNi₁₋ₓMₓO₂ (M=Co, Mn, Al, Cu, Fe, Mg, B or Ga, and x=0.01 to 0.3); lithium manganese complex oxide represented by Chemical Formula LiMn₂₋ₓMₓO₂ (M=Co, Ni, Fe, Cr, Zn or Ta, and x=0.01 to 0.1) or Li₂Mn₃MO₈ (M=Fe, Co, Ni, Cu or Zn); LiMn₂O₄ in which a portion of Li is substituted with alkaline earth ions; a disulfide compound; Fe₂(MoO₄)₃, and the like. However, this embodiment is not limited thereto.

The conductive agent may be generally added at 1% to about 50% by weight based on the total weight of the mixture including the positive electrode active material 1012. The conductive agent is usually made of a material having conductivity without causing the chemical change. The conductive agent may include, for example, conductive materials such as: graphite such as natural graphite and artificial graphite; carbon black such as acetylene black, Ketjen black, furnace black, channel black, lamp black, and thermal black; conductive fiber such as carbon fiber and metal fiber; metal powder such as carbon fluorine, aluminum, and nickel powder; conductive whisker such as zinc oxide and potassium titanate; conductive oxide such as titanium oxide; or polyphenylene derivatives.

The binder may be a component assisting the bonding of the active material to the conductive agent and the bonding to the collector and may be commonly added at 1 wt% to 50 wt% based on the total weight of the mixture including the positive electrode active material 1012. Examples of the binder may include polyfluoro vinylidene, polyvinyl alcohol, carboxymethyl cellulose (CMC), starch, hydroxypropyl cellulose, regenerated cellulose, polyvinyl pyrrolidone, tetrafluoroethylene, polyethylene, polypropylene, ethylenepropylene-diene polymer (EPDM), sulfonated EPDM, styrene butadiene rubber, fluorine rubber, various copolymers, and the like.

The filler is optionally used as a component that inhibits expansion of the positive electrode 101. Also, a general filler may be used if the filler is a fibrous material without causing the chemical change. Examples of the filler may include olefin polymers such as polyethylene and polypropylene; and fibrous materials such as glass fibers and carbon fibers.

The negative electrode 102 may be manufactured by, for example, applying the negative electrode active material 1022 on the negative electrode collector 1021 and then drying and pressing the negative electrode active material 1022. If necessary, the negative electrode active material 1022 may optionally include a conductive agent, a binder, a filler, and the like. The negative electrode 102 may be manufactured in a sheet shape and mounted on a roll.

The negative electrode collector 1021 generally has a thickness of 3 µm to 500 µm. The negative electrode collector 1021 is usually made of a material having conductivity without causing a chemical change. Examples of the material include copper, stainless steel, aluminum, nickel, titanium, calcined carbon, copper or stainless steel on which carbon, nickel, titanium, silver, or the like is surface-treated on a surface thereof, or aluminum-cadmium alloys. In addition, the negative electrode collector 1021 may form fine unevenness on the surface of the negative electrode collector 1021 to increase in bonding force of the negative electrode active material 1022. Also, the negative electrode collector 1021 may have various shapes such as a film, a sheet, a foil, a net, a porous body, a foam, or a non-woven fabric.

The negative electrode active material 1022 may include, for example, carbon such as non-graphitized carbon, graphite-based carbon, etc.; a metal complex oxide such as LixFe₂O₃ (0≤x≤1), LixWO₂ (0≤x≤1), SnxMe1-xMe'yOz (Me: Mn, Fe, Pb, Ge; Me': Al, B, P, Si, elements found in Group 1, Group 2 and Group 3 in a periodic table, halogen; 0<x≤1; 1≤ y≤3; 1≤z≤8), etc.; a lithium metal; a lithium alloy; a silicon-based alloy; a tin-based alloy; a metal oxide such as SnO, SnO₂, PbO, PbO₂, Pb₂O₃, Pb₃O₄, Sb₂O₃, Sb₂O₄, Sb₂O₅, GeO, GeO₂, Bi₂O₃, Bi₂O₄, Bi₂O₅, etc.; a conductive polymer such as polyacetylene, etc.; Li-Co-Ni-based material, and the like.

Generally known polyolefin-based separators or a composite separators in which an organic or inorganic composite layer is formed on an olefin-based material may be used as the separator that insulates the electrodes 101 and 102 between the positive electrode 101 and the negative electrode 102, but is not particularly limited thereto.

According to an embodiment of the present invention, the electrode assembly 10 having the above structure is accommodated in the battery case 13, and then, the electrolyte is injected to manufacture the secondary battery 1.

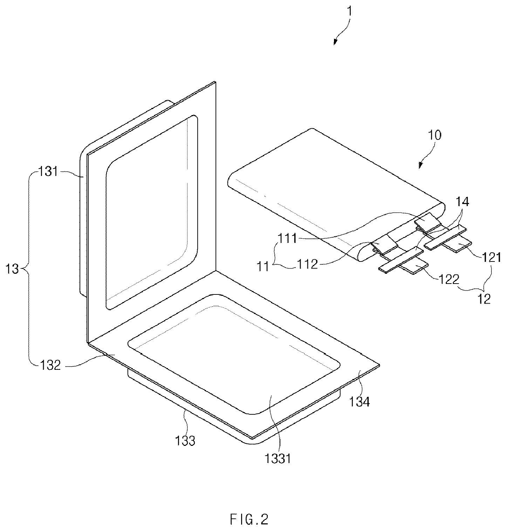

FIG. 2 is an assembly diagram of the pouch type secondary 1 battery.

In the process of manufacturing the pouch type secondary battery 1, as described above, after forming the electrode assembly 10, the electrode assembly 10 is inserted into the battery case 13 and sealed after injection of the electrolyte.

As illustrated in FIG. 1, the electrode assembly 10 includes the electrode tabs 11. The electrode tabs 11 are respectively connected to the positive electrode 101 and the negative electrode 102 of the electrode assembly 10 to protrude to the outside of the electrode assembly 10, thereby providing a path, through which electrons move, between the inside and outside of the electrode assembly 10. The electrode collectors 1011 and 1021 of the electrode assembly 10 may include active material coting portions coated with the electrode active materials 1012 and 1022 and active material non-coating portions which do not coated with the electrode active materials 1012 and 1022, respectively. Also, each of the electrode tabs 11 may be formed by cutting the active material non-coating portion or by connecting a separate conductive member to the active material non-coating portion through ultrasonic welding. As illustrated in FIG. 2, the electrode tabs 11 may protrude from one side of the electrode assembly 10 in the same direction, but the present invention is not limited thereto. For example, the electrode tabs 11 may protrude in directions different from each other.

In the electrode assembly 10, the electrode lead 12 is connected to the electrode tab 11 through spot welding. Also, a portion of the electrode lead 12 is surrounded by an insulating part 14. The insulation part 14 may be disposed to be limited within a sealing part 134, at which an upper case 131 and a lower case 132 of the battery case 13 are thermally fused, so that the electrode lead 12 is bonded to the battery case 13. Also, electricity generated from the electrode assembly 10 may be prevented from flowing to the battery case 13 through the electrode lead 12, and the sealing of the battery case 13 may be maintained. Thus, the insulation part 14 may be made of a nonconductor having non-conductivity, which is not electrically conductive. In general, although an insulation tape which is easily attached to the electrode lead 12 and has a relatively thin thickness is mainly used as the insulation part 14, the present invention is not limited thereto. For example, various members may be used as the insulation part 14 as long as the members are capable of insulating the electrode lead 12.

The electrode lead 12 may extend in the same direction or extend in directions different from each other according to the formation positions of the positive electrode tab 111 and the negative electrode tab 112. The positive electrode lead 121 and the negative electrode lead 122 may be made of materials different from each other. That is, the positive electrode lead 121 may be made of the same material as the positive electrode collector 1011, i.e., an aluminum (Al) material, and the negative electrode lead 122 may be made of the same material as the negative electrode collector 1021, i.e., a copper (Cu) material or a copper material coated with nickel (Ni). Also, a portion of the electrode lead 12, which protrudes to the outside of the battery case 13, may be provided as a terminal part and electrically connected to an external terminal.

In the pouch type secondary battery 1 according to an embodiment of the present invention, the battery case 13 may be a pouch made of a flexible material. Hereinafter, the case in which the battery case 13 is the pouch will be described. The battery case 13 accommodates the electrode assembly 10 so that a portion of the electrode lead 12, i.e., the terminal part is exposed and then is sealed. As illustrated in FIG. 2, the battery case 13 includes the upper case 131 and the lower case 132. A cup part 133 having an accommodation space 1331 accommodating the electrode assembly 10 is formed in the lower case 132, and the upper case 131 covers an upper portion of the accommodation space 1331 to prevent the electrode assembly 10 from being separated to the outside of the battery case 13. As illustrated in FIG. 2, one side of the upper case 131 and one side of the lower case 132 may be connected to each other. However, the present invention is not limited thereto. For example, the upper case 131 and the lower case 132 may be separately manufactured to be separated from each other.

When the electrode lead 12 is connected to the electrode tab 11 of the electrode assembly 10, and the insulation part 14 is provided on a portion of the electrode lead 12, the electrode assembly 10 may be accommodated in the accommodation space 1331 provided in the lower case 132, and the upper pouch 131 may cover the upper side of the case space 1331. Also, when the electrolyte is injected, and the sealing part formed on the edge of each of the upper case 131 and the lower case 132 is sealed, the secondary battery 1 is manufactured.

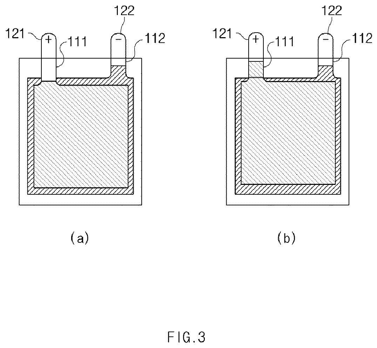

FIG. 3 is a conceptual view of the secondary battery 1 for explaining a shape of lithium dendrite. FIG. 3 illustrates a shape when viewed in a direction in which the positive electrode 101 and the negative electrode 102 are stacked.
(a) of FIG. 3 illustrates a shape of the secondary battery 1 in a normal state. The positive electrode tab 111 extends from the positive electrode 101 to expose the positive electrode lead 121 to the outside of the battery case 13. Also, the negative electrode tab 112 extends from the negative electrode 102 at the opposite side with the separator 103 therebetween to expose the negative lead 122 to the outside of the battery case 13. Here, in a normal case, a coating material is not applied to a connection portion at which the positive electrode active material 1012 is connected to the positive electrode tab 111, i.e., a neck portion of the positive electrode tab 111.

However, due to the manufacturing process, there is a case in which an area to which the coating material is applied extends beyond the neck portion of the positive electrode tab 111. (b) of FIG. 3 illustrates a shape in which the coating material is over-coated to the positive electrode tab 111.

When the coating material is over-coated to the neck portion of the anode tab 111 as described above, the following phenomenon occurs.

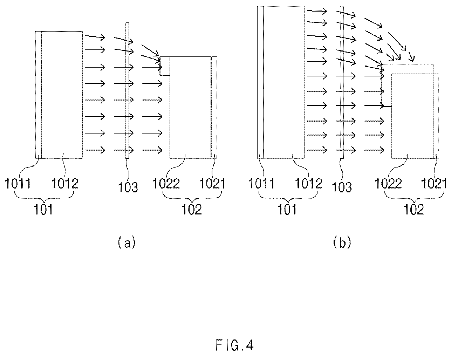

FIG. 4 is a conceptual cross-sectional view of the secondary battery for explaining an effect of the lithium dendrite. FIG. 4 illustrates a case in which the secondary battery is charged.
(a) of FIG. 4 is a conceptual view of a case in which the lithium dendrite occurs in a thickness direction of the positive electrode 101. Even when the lithium dendrite occurs in the thickness direction, reversal of a height of about 0.1 mm or less occurs between the positive electrode 101 and the negative electrode 102. Also, lithium ions generated in the positive electrode 101 existing at a position higher than the negative electrode 102 move to the nearest region of the negative electrode 102 (a portion illustrated in a rectangular shape on the surface of the negative electrode active material 1022). That is, a current density in the corresponding region increases.
(b) of FIG. 4 conceptually illustrates a case in which the lithium dendrite occurs in a plane direction of the positive electrode 101. Even when the lithium dendrite occurs in the plane direction, reversal of a height of about 0.2mm or more occurs between the positive electrode 101 and the negative electrode 102. Also, lithium ions generated in the positive electrode 101 existing at a position higher than the negative electrode 102 move to the nearest region of the negative electrode 102 (a portion illustrated in a rectangular shape on the surface of the negative electrode active material 1022). That is, a current density in the corresponding region increases. Here, unlike the case described in (a) of FIG. 4, when the lithium dendrite occurs in the plane direction as illustrated in (b) of FIG. 4, the lithium ions during the charging move to a side surface of the negative electrode active material 1022 as well as a surface of the negative electrode active material 1022.

That is, as illustrated in (a) and (b) of FIG. 4, when the lithium dendrite occurs due to the use of the secondary battery 1, it is seen that the current density in a partial area inside the secondary battery 1 abnormally varies compared to the normal state. Thus, in embodiments of the present invention, the variation in current density may be detected through a very simple configuration as described above to detect the occurrence of the lithium dendrite.

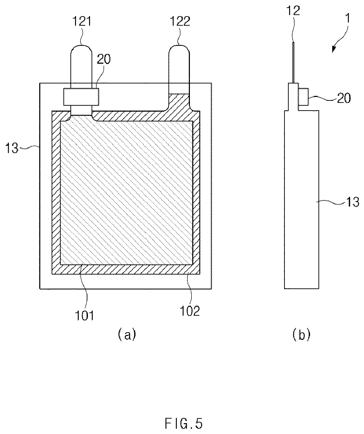

FIG. 5 is a view illustrating a configuration of the secondary battery 1 according to an embodiment of the inventive concept. (a) of FIG. 5 illustrates a shape when viewed in a direction in which the positive electrode 101 and the negative electrode 102 are stacked, and (b) of FIG. 5 illustrates a shape when viewed in a direction (the side surface of the secondary battery 1) perpendicular to the direction in which the positive electrode 101 and the negative electrode 102 are stacked.

Referring to (a) and (b) of FIG. 5, a magnetic sensor 20 as a lithium dendrite means that detects the lithium dendrite is installed at one side of the battery case 13 that accommodates the positive electrode 101 and the negative electrode 102 and then is sealed. The magnetic sensor 20 is disposed around the positive electrode tab 111 in which the lithium dendrite occurs as one side of the battery case 13. Preferably, when viewed in the direction in which the positive electrode 101 and the negative electrode 102 are stacked, the magnetic sensor 20 is disposed on an upper end of the positive electrode tab 111. That is, the magnetic sensor 20 is provided to be disposed in an upper end region of the positive electrode tab 111 as the surface of the battery case 13. Although not shown, the magnetic sensor 20 may be wiredly or wirelessly connected to the outside to transmit a measured magnetic field value to the outside.

As described above, the magnetic sensor 20 is mounted so as to detect magnetic fields generated by a current flow between the positive electrode 101 and the negative electrode 102 and a variation in magnetic field, Particularly, the magnetic sensor 20 may detect magnetic fields generated based on current flowing from the over-coated portion to the negative electrode 102 on the tab area of the positive electrode 101.

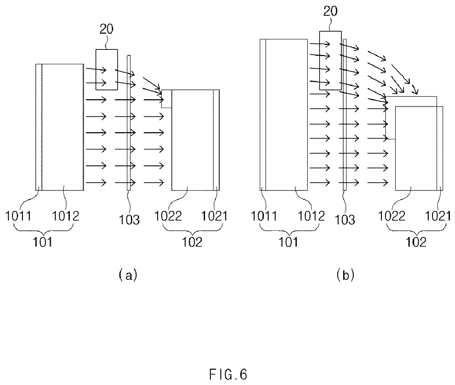

FIG. 6 is a conceptual cross-sectional view of the secondary battery 1 according to an embodiment of the present invention. FIG. 6 conceptually illustrates a case in which the magnetic sensor 20 as the lithium dendrite means is provided in the cross-sectional view of FIG. 4.

As may be seen in (a) and (b) of FIG. 6, the magnetic sensor 20 may be provided to be disposed in the upper end region of the positive electrode tab 111 as the surface of the battery case 13 to detect a variation in magnetic field due to the current density that varies by the lithium dendrite. That is, the magnetic fields, which are generated by the current generated between the lithium dendrite and the negative electrode 102 in addition to the current between the positive electrode 101 and the negative electrode 102 when the magnetic sensor 20 is charged, are measured. Also, the magnetic sensor 20 may detect the occurrence of the lithium dendrite by comparing the measured magnetic fields when the lithium dendrite occurs with the measured magnetic fields when the lithium dendrite does not occur.

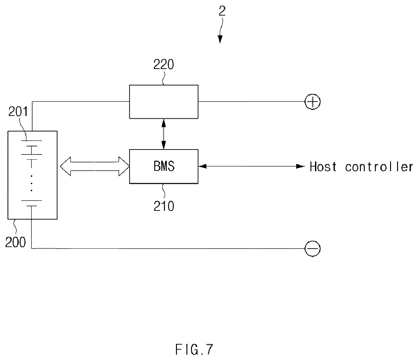

FIG. 7 is a view illustrating a battery pack 2 to which the secondary battery is applied according to an embodiment of the present invention.

The battery pack 2 may be used in the form of a battery pack for an electric vehicle or a battery rack for an energy storage device.

Referring to FIG. 7, the battery pack 2 may include a battery module 200, a battery management system 210 (hereinafter, referred to as a "BMS"), a switching part 220, and the like.

The battery module 200 includes one or more battery cells 201 that is chargeable and dischargeable. The battery module 200 may be included in the form in which a plurality of battery cells 201 are combined in series and/or in parallel. The battery cell 201 may be the above-described secondary battery 1 according to an embodiment of the present invention. The battery cell 201 may be a lithium ion (Li-ion) battery, a lithium ion polymer (Li-ion polymer) battery, or the like.

The BMS 210 may control an operation of the switching part 220 to control the charging and discharging of the battery module 200. Also, the BMS 210 may monitor a voltage, current, a temperature, etc. of the battery module 200 and/or each of the battery cells 201 included in the battery module 200. Also, in order to monitor by the BMS 210, a sensor or various measurement modules (not shown) may be additionally installed at an arbitrary position such as the battery module 200, the charging/discharging path, or the battery pack 2. The BMS 210 may calculate a parameter representing a state of the battery module 200, for example, SOC or SOH, based on measured values such as the voltage, the current, and the temperature, which are monitored. Also, the BMS 210 may transmit the calculated various data to an external device, for example, a host controller through a communication means.

The BMS 210 controls and manages an overall operation of the battery pack 2. For this, the BMS 210 may include various constituents such as a MICOM as a controller that executes program and controls an overall operation of the BMS 210, a memory that stores computer program required for the operation of the BMS 210, an input/output device such as a sensor or measuring means, a communication device for communicating with an external device, and other peripheral circuits.

In the battery pack 2 according to an embodiment of the present invention, the battery cell 201 includes a magnetic sensor 20 as a means for detecting the lithium dendrite. Thus, the BMS 210 may wiredly and/or wirelessly receive a magnetic field value measured by the magnetic sensor 20 to determine whether magnetic fields vary by the lithium dendrite and also, if there is a variation, determine whether the variation is equal to or greater than a reference value.

If it is determined that the magnetic fields received from the magnetic sensor 20 vary, and the variation in magnetic field is equal to or greater than the reference value, the BMS 210 determines that the use of the battery cell 201 is inappropriate due to the lithium dendrite. In this case, the BMS 210 may stop the operation of the battery pack 2 or may notify a fact that the lithium dendrite occurs in the corresponding battery cell 201 to the host controller.

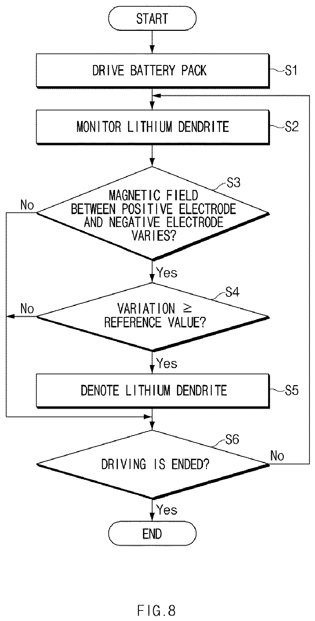

FIG. 8 is a flowchart illustrating a method for detecting lithium dendrite of the secondary battery 1 of FIG. 7.

Referring to FIG. 8, when a battery pack 2 is driven (S1), charging and discharging are performed in an individual battery cell 201. Here, as described above, if the lithium dendrite occurs during the charging and discharging, a current density varies compared to a case in which the lithium dendrite does not occur, and as a result, magnetic fields generated therearound also vary. Therefore, the magnetic fields are measured based on a magnetic sensor mounted on the battery cell 201 to monitor the lithium dendrite (S2). That is, a variation in magnetic fields is detected as a parameter for detecting the lithium dendrite.

It is determined whether the magnetic fields between a positive electrode and a negative electrode vary based on the monitored results (S3). If it is determined that there is no variation in magnetic fields (No in step S3), the process proceeds to step S6, and if the magnetic fields vary (Yes in step S3), it is determined whether the variation is equal to or greater than a reference value (S4).

When the variation in magnetic field is greater than or equal to the reference value, it is determined that the lithium dendrite occurs (Yes in step S4), and the fact that the lithium dendrite occurs is notified to the outside (S5). Of course, instead of notifying the fact that the lithium dendrite occurs to the outside, it may be possible to stop driving of the battery pack 2 or stop only an operation of the battery cell 201.

Thereafter, it is determined whether the driving of the battery pack 2 is ended (S6), and when the driving of the battery pack 2 is stopped due to the lithium dendrite, or when the use of the battery pack 2 itself is ended, a procedure for monitoring the lithium dendrite is ended, and if not, the process returns to the step S2 to repeat the above-described processes.

As described above, according to the secondary battery 1 and the battery pack 2 including the secondary battery 1 according to an embodiment of the present invention, the lithium dendrite may be accurately detected even in the secondary battery sealed by the battery case.

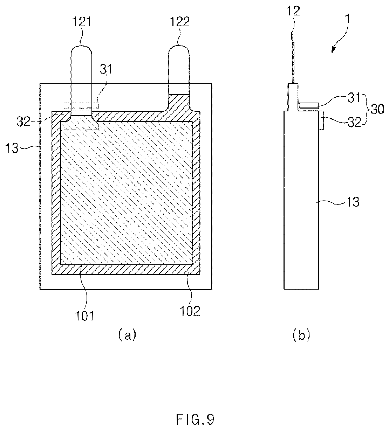

FIG. 9 is a view illustrating a configuration of a secondary battery 1 according to another embodiment of the inventive concept. (a) of FIG. 9 illustrates a shape when viewed in a direction in which a positive electrode 101 and a negative electrode 102 are stacked, and (b) of FIG. 9 illustrates a shape when viewed in a direction (a side surface of the secondary battery 1) perpendicular to a direction in which the positive electrode 101 and the negative electrode 102 are stacked.

Referring to (a) and (b) of FIG. 9, a deformation detection sensor 30 as a lithium dendrite means that detects lithium dendrite is installed at one side of a battery case 13 that accommodates the positive electrode 101 and the negative electrode 102 and then is sealed. A strain gauge may be used as the deformation detection sensor 30. The deformation detection sensor 30 is disposed around the positive electrode tab 111 in which the lithium dendrite occurs as one side of the battery case 13. Preferably, when viewed in the direction in which the positive electrode 101 and the negative electrode 102 are stacked, a magnetic sensor 20 may be disposed on an upper end of a positive electrode tab 111. Alternatively, the deformation detection sensor 30 may be disposed on an upper end of a connection portion between the positive electrode 101 and the positive electrode tab 111 of the battery case 13. Referring to the battery case 13 as a reference, the deformation detection sensor 30 may be mounted on at least one of a side surface from which the positive electrode tab 111 extends or a side surface that is in contact with (faces) the positive electrode 101 of the battery case 13, among several surfaces of the battery case 13. Although not shown, the deformation detection sensor 30 may be wiredly or wirelessly connected to the outside to transmit a measured magnetic field value to the outside.

In FIG. 9, a first deformation detection sensor 31 is formed on a side of the surface of the battery case 13, from which the positive electrode tab 111 extends. Also, a second deformation detection sensor 32 is formed on a side of the battery case 13, which faces the positive electrode 101. In FIG. 9, both the first deformation detection sensor 31 and the second deformation detection sensor 32 are illustrated, but only one sensor may be formed.

As described above, the deformation detection sensor 30 is provided around the positive electrode tab 111. When the lithium dendrite occurs, hardness of the electrode surface varies, and the variation in hardness may be detected in the battery case 13. Therefore, the deformation detection sensor 30 may be mounted at an appropriate position to detect the lithium dendrite. However, in the case of this embodiment, since the deformation of the battery case 13 due to the lithium dendrite is detected, the battery case 13 is preferably a flexible pouch.

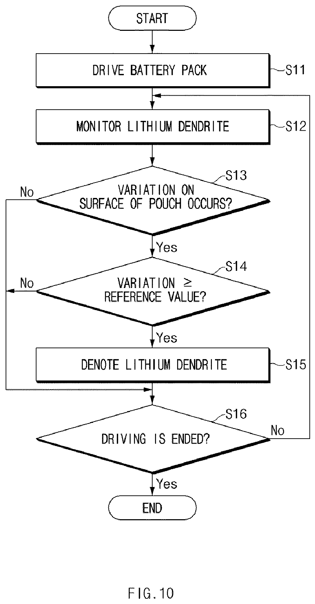

FIG. 10 is a flowchart illustrating a method for detecting lithium dendrite of the secondary battery of FIG. 9.

Referring to FIG. 10, when a battery pack 2 is driven (S11), charging and discharging are performed in an individual battery cell 201. Here, as described above, if the lithium dendrite occurs during charging and discharging, hardness of an electrode varies compared to a case in which the lithium dendrite does not occur, and as a result, the battery case 13 surrounding the electrode may be deformed. Therefore, the deformation is measured based on the deformation detection sensor mounted on the battery cell 201 to monitor the lithium dendrite (S12). That is, the deformation of the battery case 13 is detected as a parameter for detecting the lithium dendrite.

It is determined whether a displacement of the battery case 13 occurs based on the monitored results (S13). If it is determined that the displacement occurs, i.e., there is no deformation (No in step S13), the process proceeds to step S16, and if the deformation occurs (Yes in step S13), it is determined whether the displacement is equal to or greater than a reference value (S14).

When the displacement is greater than or equal to the reference value, it is determined that the lithium dendrite occurs (Yes in step S14), and the fact that the lithium dendrite occurs is notified to the outside (S15). Of course, instead of notifying the fact that the lithium dendrite occurs to the outside, it may be possible to stop driving of the battery pack 2 or stop only an operation of the battery cell 201.

Thereafter, it is determined whether the driving of the battery pack 2 is ended (S16), and when the driving of the battery pack 2 is stopped due to the lithium dendrite, or when the use of the battery pack 2 itself is ended, a procedure for monitoring the lithium dendrite is ended, and if not, the process returns to the step S12 to repeat the above-described processes.

As described above, according to the secondary battery 1 and the battery pack 2 including the secondary battery 1 according to an embodiment of the present invention, the lithium dendrite may be accurately detected even in the secondary battery sealed by the battery case.

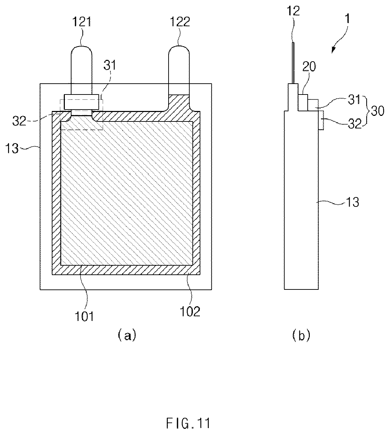

FIG. 11 is a view illustrating a configuration of a secondary battery according to further another embodiment of the present invention.

In this embodiment, a magnetic sensor 20 and a deformation detection sensor 30 are simultaneously formed as a lithium dendrite detection means. As described above, when compared to the secondary battery of FIGS. 5 and 8, in which only the magnetic sensor 20 is used, or only the deformation detection sensor 30 is used, the lithium dendrite may be more accurately detected.

The terms "comprising," "including," and "having," described above mean that the corresponding component may be present unless otherwise stated, and it should be construed as being able to further include other components, not excluding other components. All terms, including technical or scientific terms, may be interpreted as having the same meaning as commonly understood by a person of ordinary skill in the art, unless otherwise defined. Terms such as terms that are generally used and have been in dictionaries should be construed as having meanings matched with contextual meanings in the art. In this description, unless defined clearly, terms are not ideally, excessively construed as formal meanings.

The above-disclosed subject matter is to be considered illustrative, and not restrictive, and the appended claims are intended to cover all such modifications, enhancements, and other embodiments, which fall within the true spirit and scope of the present disclosure. Thus, the embodiment of the present disclosure is to be considered illustrative, and not restrictive, and the technical spirit of the present disclosure is not limited to the foregoing embodiment. Therefore, the scope of the invention is defined not by the detailed description of the invention but by the appended claims, and all differences within the scope will be construed as being included in the present invention.

## Claims

1. A secondary battery comprising:
a positive electrode and a negative electrode;
a battery case configured to seal the positive electrode and the negative electrode; and
a lithium dendrite detection means provided around a tab of the positive electrode at a side of the battery case to detect lithium dendrite.

2. The secondary battery of claim 1, wherein the lithium dendrite detection means comprises a magnetic sensor provided on a tab area of the positive electrode in the battery case.

3. The secondary battery of claim 2, wherein the magnetic sensor is mounted to detect a variation in magnetic field generated between the tab area of the positive electrode and the negative electrode.

4. The secondary battery of claim 2, wherein the magnetic sensor detects magnetic fields generated based on current flowing from an over-coated portion of the tab area of the positive electrode to the negative electrode.

5. The secondary battery of claim 1, wherein the lithium dendrite detection means comprises a deformation detection sensor provided on a tab area of the positive electrode in the battery case.

6. The secondary battery of claim 5, wherein the deformation detection sensor is a strain gauge.

7. The secondary battery of claim 7, wherein the strain gauge is formed on a side of a surface of the battery case, which is in contact with the positive electrode, or a side of a surface of the battery case, from which the tab extends.

8. The secondary battery of claim 5, wherein the battery case is a flexible pouch.

9. A method for detecting lithium dendrite in a second battery, in which a positive electrode and a negative electrode are accommodated in a battery case, the method comprising:
a step of detecting a variation of a preset parameter based on a lithium dendrite detection means provided around a tab of the positive electrode at a side of the battery case;
a step of determining whether the variation of the parameter is equal to or less than a reference value; and
a step of determining lithium dendrite based on the determined results.

10. The method of claim 9, wherein the lithium dendrite detection means comprises a magnetic sensor provided on a tab area of the positive electrode in the battery case, and
in the step of detecting the variation of the parameter, a variation in magnetic field, which is measured by the magnetic sensor, is detected.

11. The method of claim 9, wherein the lithium dendrite detection means comprises a deformation detection sensor provided on a tab area of the positive electrode in the battery case, and
in the step of detecting the variation of the parameter, deformation of the battery case that is a flexible pouch, which is measured by the deformation detection sensor, is detected.
